# EUROPEAN PATENT APPLICATION

(11) **EP 4 468 402 A1**
(43) Date of publication of application: **27.11.2024**
(21) Application number: 23907601.1
(22) Date of filing: 14.12.2023
(51) Int. Cl.: H01M 4/139, G01R 31/382, G01R 31/367, G01R 31/396, H01M 10/052

(54) **APPARATUS AND METHOD FOR DIAGNOSING PRE-LITHIATION**

(30) Priority: 21.12.2022 KR 20220181100
(71) Applicant: LG Energy Solution, Ltd., Seoul 07335 (KR)
(72) Inventor: CHOI, Soon-Ju, Daejeon 34122 (KR); KWON, Yo-Han, Daejeon 34122 (KR); KIM, Dae-Soo, Daejeon 34122 (KR); KIM, Young-Deok, Daejeon 34122 (KR); PARK, Seung-Won, Daejeon 34122 (KR); PARK, Hyun-Woo, Daejeon 34122 (KR)
(74) Representative: Goddar, Heinz J.
(86) International application number: PCT/KR2023/020690
(87) International publication number: WO 2024/136315

(57) **Abstract**

An apparatus for diagnosing pre-lithiation according to one aspect of the present disclosure may include a memory unit storing a positive electrode reference starting value and a negative electrode reference starting value for a reference battery, and a control unit configured to obtain a positive electrode target profile and a negative electrode target profile for a target battery to be diagnosed, recognize a positive electrode target starting value and a negative electrode target starting value from the positive electrode target profile and the negative electrode target profile, and determine a lithium charge amount of a pre-lithiation process for the target battery based on at least one of the positive electrode reference starting value, the negative electrode reference starting value, the positive electrode target starting value, and the negative electrode target starting value.

## Description

### TECHNICAL FIELD

The present application claims priority to Korean Patent Application No. 10-2022-0181100 filed on December 21, 2022 in the Republic of Korea, the disclosures of which are incorporated herein by reference.

The present disclosure relates to an apparatus and method for diagnosing pre-lithiation, and more specifically, to an apparatus and method for diagnosing a state of a battery based on an amount of lithium in the battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

The conventional lithium battery uses compounds with lithium inserted into the positive electrode, such as LiCoO₂ and LiMn₂O₄, so the battery is manufactured in a state where lithium is not inserted into the electrode used as the negative electrode. When the electrode used as the negative electrode is a carbon electrode, a passive film is formed on the surface of the carbon electrode during initial charging. This film prevents the organic solvent from being inserted between the carbon lattice layers and suppresses the decomposition reaction of the organic solvent, thereby stabilizing the carbon structure and improving the reversibility of the carbon electrode, so it may be used as a negative electrode for lithium batteries.

However, because this film formation reaction is an irreversible reaction, it has the adverse effect of reducing battery capacity by consuming lithium ions. In addition, since the charge/discharge efficiency of the carbon electrode and the positive electrode is not completely 100%, lithium ions are consumed as the number of cycles progresses, which may reduce electrode capacity and ultimately reduce cycle life.

To compensate for the reduced electrode capacity, a pre-lithiation process is used to supply lithium to the negative electrode in advance during the battery manufacturing stage. When a pre-lithiation process is used in the manufacturing stage to manufacture a battery containing a pre-lithiated negative electrode, it is necessary to diagnose whether the predesigned amount of lithium has been supplied to the negative electrode. For example, at least part of the lithium may be lost unexpectedly during storage or manufacturing process of the completed battery, so it is necessary to check whether the lithium charge amount designed for the finally completed battery is accurately reflected. However, in order to check the lithium charge amount, there is a problem that the completed battery must be disassembled and the negative electrode must be discharged to check the lithium charge amount. Therefore, there is a need to develop a technology that may check the lithium charge amount of the negative electrode without disassembling the battery.

### DISCLOSURE

### Technical Problem

The present disclosure is designed to solve the problems of the related art, and therefore the present disclosure is directed to providing an apparatus and method for diagnosing pre-lithiation, which may non-destructively diagnose a pre-lithiation state of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing pre-lithiation according to one aspect of the present disclosure may comprise a memory unit storing a positive electrode reference starting value and a negative electrode reference starting value for a reference battery; and a control unit configured to obtain a positive electrode target profile and a negative electrode target profile for a target battery to be diagnosed, recognize a positive electrode target starting value and a negative electrode target starting value from the positive electrode target profile and the negative electrode target profile, and determine a lithium charge amount of a pre-lithiation process for the target battery based on at least one of the positive electrode reference starting value, the negative electrode reference starting value, the positive electrode target starting value, and the negative electrode target starting value.

The control unit may be configured to determine the lithium charge amount based on the negative electrode reference starting value and the negative electrode target starting value.

The control unit may be configured to calculate a difference between the negative electrode reference starting value and the negative electrode target starting value and determine the lithium charge amount based on the calculated difference and a preset positive electrode loading amount.

The control unit may be configured to determine the lithium charge amount based on a first difference between the negative electrode reference starting value and the positive electrode reference starting value and a second difference between the negative electrode target starting value and the positive electrode target starting value.

The control unit may be configured to calculate a third difference between the first difference and the second difference and determine the lithium charge amount based on the calculated third difference and a preset positive electrode loading amount.

The reference battery may include is a battery to which no lithium is charged or a preset amount of lithium is charged in the pre-lithiation process.

The positive electrode reference starting value and the negative electrode reference starting value may be configured to be set as a positive electrode SOC and a negative electrode SOC of the reference battery, respectively, when a SOC of the reference battery corresponds to a preset reference SOC.

The apparatus for diagnosing pre-lithiation may further comprise a measuring unit configured to measure a voltage of the target battery, and the control unit may be configured to generate a full-cell profile for the target battery based on the voltage measured from the measuring unit and obtain the positive electrode target profile and the negative electrode target profile from the full-cell profile.

The memory unit may be configured to store a positive electrode reference profile and a negative electrode reference profile for the reference battery, and the control unit may be configured to obtain the positive electrode target profile and the negative electrode target profile, respectively, by adjusting the positive electrode reference profile and the negative electrode reference profile to correspond to the full-cell profile.

The control unit may be configured to compare the lithium charge amount and a preset reference charge amount and diagnose a state of the target battery based on the comparison result.

A battery manufacturing device according to another aspect of the present disclosure may comprise the apparatus for diagnosing pre-lithiation according to the present disclosure.

A method for diagnosing pre-lithiation according to still another aspect of the present disclosure may comprise a target profile obtaining step of obtaining a positive electrode target profile and a negative electrode target profile for a target battery to be diagnosed; a target starting value recognizing step of recognizing a positive electrode target starting value and a negative electrode target starting value from the positive electrode target profile and the negative electrode target profile; and a lithium charge amount determining step of determining a lithium charge amount of a pre-lithiation process for the target battery based on at least one of a positive electrode reference starting value for a reference battery, a negative electrode reference starting value for the reference battery, the positive electrode target starting value, and the negative electrode target starting value.

### Advantageous Effects

According to one aspect of the present disclosure, an apparatus for diagnosing pre-lithiation is provided that may check the amount of lithium charge previously supplied to the negative electrode.

In particular, in the case of the present disclosure, the lithium charge amount may be confirmed without disassembling the completed battery, that is, non-destructively. Therefore, the state of the battery may be diagnosed more easily and quickly.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus 100 for diagnosing pre-lithiation according to an embodiment of the present disclosure.
FIG. 2 shows an example profile for a reference battery.
FIG. 3 shows an example profile for a target battery.
FIG. 4 is a diagram to explain the creation of a positive electrode target profile and a negative electrode target profile from a full-cell profile Tf of the target battery.
FIG. 5 is a flowchart schematically showing a method for diagnosing pre-lithiation according to an embodiment of the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise. Additionally, terms such as memory unit, control unit, and measuring unit described in the specification refer to a unit that processes at least one function or operation, and may be implemented as hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

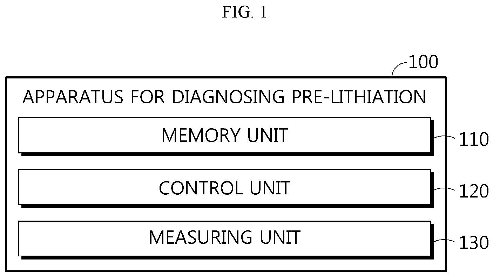

FIG. 1 is a diagram schematically showing an apparatus 100 for diagnosing pre-lithiation according to an embodiment of the present disclosure.

Referring to FIG. 1, the apparatus 100 for diagnosing pre-lithiation may include a memory unit 110 and a control unit 120.

The memory unit 110 may store data or programs necessary for each component of the apparatus 100 for diagnosing pre-lithiation to perform operations and functions, or data generated in the process of performing operations and functions. The memory unit 110 may be internal or external to the control unit 120 and may be connected to the control unit 120 by various well-known means. The memory unit 110 may store at least one program, application, data, or instructions executed by the control unit 120. There is no particular limitation on the type of the memory unit 110 as long as it is a known information storage means capable of recording, erasing, updating, and reading data. The memory unit 110 may be implemented as at least one of a flash memory type, a hard disk type, a SSD (Solid State Disk) type, a SDD (Solid Disk Drive) type, a multimedia card micro type, RAM (Random Access Memory), SRAM (Static RAM), ROM (Read Only Memory), EEPROM (Electrically Erasable Programmable Read Only Memory), and PROM (Programmable Read Only Memory), but the present disclosure is not necessarily limited to the specific form of the memory unit 110. Additionally, the memory unit 110 may store program codes in which processes executable by the control unit 120 are defined.

According to one embodiment, the memory unit 110 may be configured to store a positive electrode reference starting value and a negative electrode reference starting value for a reference battery. Here, the reference battery may be a battery of the same type as a target battery to be diagnosed or designed to have the same characteristics as the target battery to be diagnosed. Here, the battery refers to an independent cell that has a negative electrode terminal and a positive electrode terminal and is physically separable. As an example, a lithium-ion battery may be considered a battery. Additionally, the battery may mean a battery module in which a plurality of cells are connected in series and/or parallel. Below, for convenience of explanation, the battery is explained as meaning one independent cell.

In one embodiment, the reference battery may refer to a battery that has not been subjected to a pre-lithiation process to supply lithium ions to the negative electrode in advance during the manufacturing stage, when compared to the target battery. In another example, the reference battery may be a battery in which the amount of lithium ions supplied through the pre-lithiation process can be known with high reliability, that is, the amount of lithium ions supplied in advance is accurately known. Hereinafter, the reference battery is explained as meaning a battery to which no pre-lithiation process has been applied. Additionally, the amount of lithium ions supplied in advance through the pre-lithiation process is referred to as lithium charge amount, for convenience of explanation.

The positive electrode reference starting value and the negative electrode reference starting value may be configured to be set as a positive electrode SOC and a negative electrode SOC of the reference battery, respectively, when the SOC (state of charge, charge amount) of the reference battery corresponds to a preset reference SOC.

Specifically, the positive electrode reference starting value and the negative electrode reference starting value may be set as a characteristic value of the positive electrode and a characteristic value of the negative electrode of the reference battery, respectively, when the SOC of the reference battery corresponds to the preset reference SOC. In one embodiment, the positive electrode reference starting value may refer to a positive electrode SOC or a positive electrode voltage value when the reference battery corresponds to the predetermined SOC, and the negative electrode reference starting value may refer to a negative electrode SOC or a negative electrode voltage value when the reference battery corresponds to the predetermined SOC.

Even if one battery (e.g., reference battery or target battery) containing a negative electrode and a positive electrode has an SOC corresponding to a set value, the negative electrode SOC and the positive electrode SOC may differ from the set value. There is a lower limit voltage and an upper limit voltage at which the battery can operate, and each electrode may have a predetermined charge amount in the range below the lower limit voltage and above the upper limit voltage. For example, even if the SOC of the battery is 0%, which is a fully discharged state, the charge amount of the negative electrode may not be 0% but may have a predetermined charge amount. Also, even when the SOC of the battery is 0%, the charge amount of the positive electrode may not be 0% but may have a predetermined charge amount.

The memory unit 110 may store information about the positive electrode SOC and information about the negative electrode SOC of the reference battery at a predetermined SOC, for example, SOC 0% or SOC 10%, for the reference battery that has not undergone a pre-lithiation process. For example, at SOC 0%, which is the fully discharged state of the reference battery, the positive electrode SOC may be 4.5% and the negative electrode SOC may be 0.7%. In this case, the positive electrode reference starting value may be said to be 4.5%, and the negative electrode reference starting value may be said to be 0.7%.

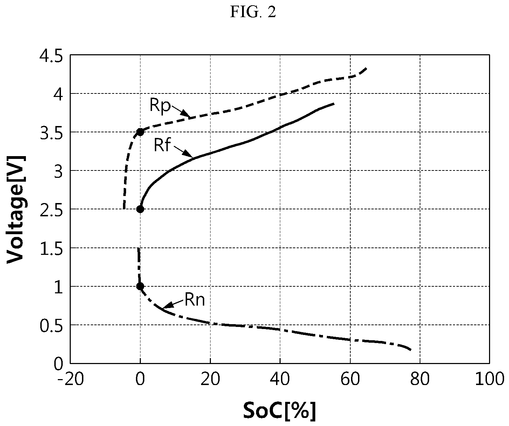

FIG. 2 shows an example profile for a reference battery. The profile for this reference battery is stored in the memory unit 110, and the control unit 120, which will be described later, may read the positive electrode reference starting value and the negative electrode reference starting value from the profile. Alternatively, the profile for the reference battery may not be stored in the memory unit 110 as is, but the positive electrode reference starting value and the negative electrode reference starting value obtained from the profile for the reference battery may be stored in the memory unit 110 as reference data. Additionally, the memory unit 110 may further store a mapping table (not shown) indicating the corresponding relationship between the positive electrode SOC and the positive electrode voltage and the corresponding relationship between the negative electrode SOC and the negative electrode voltage.

Referring to FIG. 2, an example of the full-cell profile Rf, the positive electrode reference profile Rp, and the negative electrode reference profile Rn for the reference battery is shown. The x-axis of the graph in FIG. 2 represents SOC (%), and the y-axis represents voltage (V). The full-cell profile Rf, the positive electrode reference profile Rp, and the negative electrode reference profile Rn for this reference battery may be stored in the memory unit 110, or data sets constituting the profiles (e.g., positive electrode SOC and negative electrode SOC according to the SOC of the reference battery) may be stored in the memory unit 110.

Referring to FIG. 2, it is confirmed that when the SOC of the reference battery is 0%, the full-cell voltage is 2.5 V, the positive electrode voltage is 3.5 V, and the negative electrode voltage is 1 V. According to the mapping table stored in the memory unit 110, when the positive electrode voltage is 3.5 V, the positive electrode SOC may be 4.5%, and when the negative electrode voltage is 1 V, the negative electrode SOC may be 0.7%. In the example, when the SOC of the reference battery corresponds to a predetermined SOC (e.g., SOC 0%), the positive electrode reference starting value may be set to 4.5%, which is the positive electrode SOC, and the negative electrode reference starting value may be set to 0.7%, which is the negative electrode SOC. Please note that the numbers are just examples and may vary depending on the characteristics of the battery.

The control unit 120 is operatively connected to other components such as the memory unit 110 or the measuring unit 130 of the apparatus 100 for diagnosing pre-lithiation, and may control various operations of the apparatus 100 for diagnosing pre-lithiation.

The control unit 120 may perform various operations of the apparatus 100 for diagnosing pre-lithiation by executing one or more instructions. The control unit 120 may optionally include processors, application-specific integrated circuits (ASICs), chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory unit 100 and executed by the control unit 120.

According to one embodiment, the control unit 120 may be configured to obtain a positive electrode target profile and a negative electrode target profile for a target battery to be diagnosed.

As an example, the positive electrode target profile and the negative electrode target profile may be obtained through a 3-electrode analysis method for the target battery or by directly discharging from a coin cell type generated by disassembling the target battery.

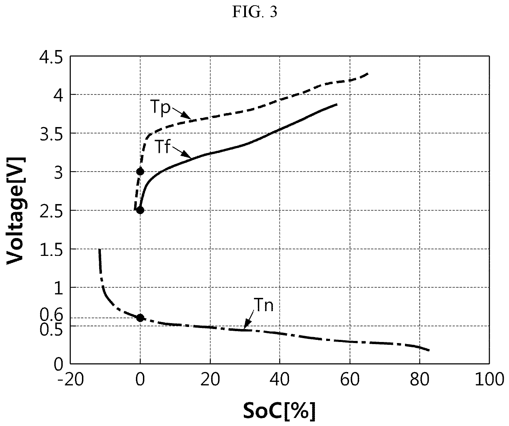

Preferably, the control unit 120 may obtain the positive electrode target profile and the negative electrode target profile for the target battery in a non-destructive manner. Specifically, the control unit 120 may obtain a full-cell profile for the target battery, and obtain a positive electrode target profile and a negative electrode target profile from the obtained full-cell profile. Referring to FIG. 3, an embodiment in which the control unit 120 recognizes a positive electrode target starting value and a negative electrode target starting value from the positive electrode target profile and the negative electrode target profile will be described.

FIG. 3 shows an example profile for a target battery.

Referring to FIG. 3, an example of the full-cell profile Tf, the positive electrode target profile Tp, and the negative electrode target profile Tn for the target battery is shown.

The x-axis of the graph in FIG. 3 represents SOC (%), and the y-axis represents voltage (V).

Depending on the state of the target battery, that is, depending on the lithium charge amount pre-charged in the target battery through the pre-lithiation process, the profile (full-cell profile Tf, positive electrode target profile Tp, and negative electrode target profile Tn) of the target battery may be different, and it may be understood that FIG. 3 is an example of such a profile of the target battery. The control unit 120 may obtain the full-cell profile Tf for the target battery, and obtain the positive electrode target profile Tp and the negative electrode target profile Tn from the obtained full-cell profile Tf in a non-destructive manner without disassembling the target battery.

According to one embodiment, the control unit 120 may be configured to recognize a positive electrode target starting value and a negative electrode target starting value from the positive electrode target profile Tp and the negative electrode target profile Tn.

The positive electrode target starting value and negative electrode target starting value may be set as the characteristic value of the positive electrode and the characteristic value of the negative electrode, respectively, when the SOC of the target battery corresponds to the preset reference SOC. Specifically, the positive electrode target starting value may mean a positive electrode SOC or a positive electrode voltage value when the target battery corresponds to the predetermined SOC, and the negative electrode target starting value may mean a negative electrode SOC or a negative electrode voltage value when the target battery corresponds to the predetermined SOC.

Here, the reference SOC for obtaining the above-described positive electrode reference starting value and the above-described negative electrode reference starting value and the reference SOC for obtaining the positive electrode target starting value and the negative electrode target starting value may be the same. If the control unit 120 obtains the positive electrode reference starting value, the negative electrode reference starting value, the positive electrode target starting value, and the negative electrode target starting value at the same SOC in this way, the accuracy of the calculated lithium charge amount may be improved.

In one embodiment, the control unit 120 may obtain and recognize the positive electrode reference starting value, the negative electrode reference starting value, the positive electrode target starting value, and the negative electrode target starting value when the SOC of the reference battery is 0% and the SOC of the target battery is 0%. Alternatively, the control unit 120 may obtain and recognize the positive electrode reference starting value, the negative electrode reference starting value, the positive electrode target starting value, and the negative electrode target starting value when the SOC of the reference battery is 10% and the SOC of the target battery is 10%. In various embodiments, the SOC of the battery from which the positive electrode reference starting value, the negative electrode reference starting value, the positive electrode target starting value, and the negative electrode target starting value are obtained may be changed.

Specifically, the control unit 120 may recognize the positive electrode target starting value and the negative electrode target starting value based on a mapping table (not shown) indicating the corresponding relationship between the positive electrode SOC and the positive electrode voltage and the corresponding relationship between the negative electrode SOC and the negative electrode voltage stored in the memory unit 110.

Referring to FIG. 3, it is confirmed that when the SOC of the target battery is 0%, the full-cell voltage is 2.5 V, the positive electrode voltage is 3 V, and the negative electrode voltage is about 0.6 V. According to the mapping table stored in the memory unit 110, when the positive electrode voltage is 3 V, the positive electrode SOC may be 1.1%, and when the negative electrode voltage is 0.6 V, the negative electrode SOC may be 11.4%. In the example, when the SOC of the target battery corresponds to a predetermined SOC (e.g., SOC 0%), the positive electrode target starting value may be set to 1.1%, which is the positive electrode SOC, and the negative electrode target starting value may be set to 11.4%, which is the negative electrode SOC. Please note that the numbers are just examples and may vary depending on the characteristics of the battery.

According to one embodiment, the control unit 120 may be configured to determine the lithium charge amount in the pre-lithiation process for the target battery based on at least one of the positive electrode reference starting value, the negative electrode reference starting value, the positive electrode target starting value, and the negative electrode target starting value.

Specifically, the control unit 120 may calculate the lithium charge amount for the target battery pre-charged in the pre-lithiation process by calculating at least two parameters selected from the recognized positive electrode reference starting value, the recognized negative electrode reference starting value, the recognized positive electrode target starting value, and the recognized negative electrode target starting value.

According to this implementation configuration of the present disclosure, the lithium charge amount pre-charged in the target battery to be diagnosed may be calculated in a simple manner. Therefore, since the lithium charge amount may be calculated without disassembling a battery that has already been manufactured, it is possible to check whether the battery has been charged with lithium as designed. Therefore, battery abnormalities may be diagnosed in a simple and accurate manner. Below, a detailed embodiment of determining the lithium charge amount will be described.

According to one embodiment, the control unit 120 may be configured to determine the lithium charge amount based on the negative electrode reference starting value and the negative electrode target reference value.

For example, referring to FIGS. 2 and 3, if the SOCs of the target battery and the reference battery are 0% as described above, the negative electrode SOC of the reference battery may be 0.7% and the negative electrode SOC of the target battery may be 11.4%. That is, the control unit 120 may recognize the negative electrode reference starting value as 0.7% and the negative electrode target starting value as 11.4%.

The control unit 120 may calculate the difference between the negative electrode reference starting value and the negative electrode target starting value using the formula " negative electrode reference starting value - negative electrode target starting value|". For example, if the negative electrode reference starting value is 0.7% and the negative electrode target starting value is 11.4%, the difference may be 10.7%. The control unit 120 may recognize that the target battery is pre-lithiated by an amount corresponding to the difference between the negative electrode reference starting value and the negative electrode target starting value. That is, the control unit 120 may determine the lithium charge amount corresponding to the difference between the negative electrode reference starting value and the negative electrode target starting value.

Specifically, the control unit 120 may determine the lithium charge amount based on the difference between the negative electrode reference starting value and the negative electrode target starting value and a preset loading amount. The loading amount may be any one of the negative electrode loading amount and the positive electrode loading amount. Below, it will be explained as an example that the lithium charge amount is determined based on the positive electrode loading amount.

For example, as described above, if the difference between the negative electrode reference starting value and the negative electrode target starting value is calculated to be 10.7%, the control unit 120 may determine the value obtained by multiplying the calculated difference and a preset positive electrode loading amount, that is, the positive electrode loading amount of the target battery, as the lithium charge amount of the target battery. In other words, the control unit 120 may determine the lithium charge amount using the formula " negative electrode reference starting value - negative electrode target starting value| × positive electrode loading amount ÷ 100". In this formula, 100 is based on that the difference between the negative electrode reference starting value and the negative electrode target starting value is expressed as SOC with the unit of %, and is omitted when SOC is expressed as a number between 0 and 1.

If the positive electrode loading amount of the target battery is preset to 3 mAh/cm², the control unit 120 may determine that lithium (lithium ions) is pre-charged in the negative electrode of the target battery through a pre-lithiation process to an amount of about 0.321 mAh/cm² that is obtained by calculating the formula of 10.7 × 3 ÷ 100.

In one embodiment, the control unit 120 may determine the lithium charge amount based on the movement amount of the negative electrode starting value based on the positive electrode starting value. During the manufacturing process or the storage process of the finished battery, the characteristic value of the battery may change for various reasons. In this case, the negative electrode profile and the positive electrode profile of the battery are shifted together to have the same tendency. Therefore, if the movement amount of the negative electrode profile is calculated based on the positive electrode profile and the calculated movement amounts are compared between the target battery and the reference battery, the lithium charge amount may be calculated with improved accuracy.

The control unit 120 may calculate the difference between the negative electrode reference starting value and the positive electrode reference starting value. For example, as described with reference to FIG. 2, the positive electrode reference starting value may be 4.5% and the negative electrode reference starting value may be 0.7%. The control unit 120 may calculate the difference as -3.8% using the formula "|negative electrode reference starting value - positive electrode reference starting value|". The calculated value may be referred to as a first difference.

The control unit 120 may calculate the difference between the negative electrode target starting value and the positive electrode target starting value. For example, as described with reference to FIG. 3, the positive electrode target starting value may be 1.1% and the negative electrode target starting value may be 11.4%. The control unit 120 may calculate the difference as 10.3% using the formula "|negative electrode target starting value - positive electrode target starting value|". The calculated value may be referred to as a second difference.

The control unit 120 may determine the lithium charge amount based on the first difference and the second difference.

The control unit 120 may calculate 14.1% using the formula "|first difference - second differencel". The control unit 120 may recognize that the target battery is pre-discharged by the amount corresponding to the third difference between the first difference and the second difference. In other words, the control unit 120 may determine the lithium charge amount corresponding to the difference (third difference) between the difference (first difference) between the negative electrode reference starting value and the positive electrode reference starting value and the difference (second difference) between the negative electrode target starting value and the positive electrode target starting value. In this case, the unique characteristics of the battery, that is, the shift amount of the profile may be reflected, so the apparatus for diagnosing pre-lithiation according to the present disclosure may determine more accurate lithium charge amount.

Specifically, the control unit 120 may determine the lithium charge amount based on the third difference between the first difference and the second difference and a preset loading amount. The loading amount may be any one of the negative electrode loading amount and the positive electrode loading amount. Below, it will be explained as an example that the lithium charge amount is determined based on the positive electrode loading amount.

For example, if the third difference between the first difference and the second difference is calculated as 14.1% as described above, the control unit 120 may determine the value obtained by multiplying the calculated third difference by a preset positive electrode loading amount, that is, the positive electrode loading amount of the target battery as the lithium charge amount of the target battery. In other words, the control unit 120 may determine the lithium charge amount using the formula "|first difference - second difference! × positive electrode loading amount ÷ 100". Similarly, in this formula, 100 is based on that the first difference and the second difference are expressed as SOC with the unit of %, and is omitted when SOC is expressed as a number between 0 and 1.

If the positive electrode loading amount of the target battery is preset to 3 mAh/cm², the control unit 120 may determine that the negative electrode of the target battery is pre-charged with lithium (lithium ions) through a pre-lithiation process by an amount of about 0.423 mAh/cm² that is obtained by calculating the formula of 14.1 × 3 ÷ 100.

Additionally, in one embodiment, the reference battery may include a battery to which no lithium is charged or a preset amount of lithium is charged in the pre-lithiation process.

If the reference battery has not been charged with lithium in the pre-lithiation process, that is, if the reference battery has not undergone a pre-lithiation process, the control unit 120 may determine the lithium charge amount of the target battery in the above-described manner. In various embodiments, if the reference battery has undergone a pre-lithiation process, the control unit 120 may determine the lithium charge amount of the target battery by compensating for the lithium charge amount included in the reference battery. For example, if the lithium charge amount pre-charged in the reference battery is 0.1 mAh/cm² and this value has reliable accuracy, the control unit 120 may determine the final lithium charge amount for the target battery by adding 0.1 mAh/cm², which is the charged lithium charge amount pre-charged in the reference battery, to the lithium charge amount calculated in the above-described manner. Therefore, according to the embodiment of the present disclosure, it is possible to determine the lithium charge amount universally without restrictions on the conditions of the reference battery and very accurately using a simple formula.

According to one embodiment, the control unit 120 may be configured to diagnose the state of the target battery by comparing the lithium charge amount and a preset reference charge amount.

The preset reference charge amount may refer to the amount of lithium designed to pre-charge the negative electrode of the target battery in the pre-lithiation process.

The control unit 120 may calculate the lithium charge amount pre-charged in the target battery according to the above-described embodiment and compare the calculated lithium charge amount with the preset reference charge amount. The control unit 120 may diagnose the state of the target battery based on the comparison result.

Specifically, when the calculated lithium charge amount is less than the preset reference charge amount, the control unit 120 may determine that the amount of lithium charged in the target battery in the pre-lithiation process is less than the designed amount, and diagnose that the target battery is a defective battery. Alternatively, if the calculated lithium charge amount is greater than or equal to the preset reference charge amount, the control unit 120 may determine that the amount of lithium charged in the target battery in the pre-lithiation process corresponds to the designed amount and diagnose that the target battery is a normal battery. Preferably, the control unit 120 may diagnose that the target battery is a normal battery when the calculated lithium charge amount is greater than or equal to the preset reference charge amount and is within a predetermined error range. According to one implementation of the present disclosure, the apparatus 100 for diagnosing pre-lithiation may quantitatively confirm the amount of lithium charged in the pre-lithiation process without disassembling the target battery, and thus quickly and accurately determine whether the target battery is a normal battery produced to correspond on the designed amount of lithium.

Meanwhile, below, it is explained that the apparatus 100 for diagnosing pre-lithiation according to the present disclosure obtains a positive electrode target profile and a negative electrode target profile for the target battery in a non-destructive manner.

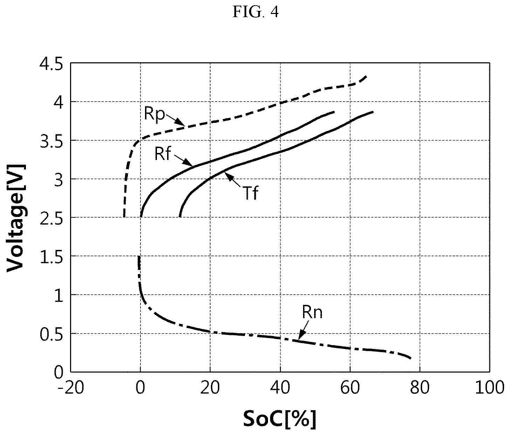

FIG. 4 is a diagram to explain the creation of a positive electrode target profile and a negative electrode target profile from a full-cell profile Tf of the target battery. The x-axis of the graph in FIG. 4 represents SOC (%), and the y-axis represents voltage (V).

Referring to FIG. 4, the negative electrode reference profile Rn and the positive electrode reference profile Rp stored in the memory unit 110 are shown. For convenience of understanding, the full-cell profile Rf of the reference battery corresponding to the difference between the negative electrode reference profile Rn and the positive electrode reference profile Rp is shown. Here, since the control unit 120 may obtain the full-cell profile Rf or data constituting the full-cell profile Rf from the difference between the prestored negative electrode reference profile Rn and the positive electrode reference profile Rp, the full-cell profile Rf of the reference battery does not necessarily have to be stored in advance in the memory unit 110.

As shown in FIG. 1, the apparatus 100 for diagnosing pre-lithiation according to the embodiment may further include a measuring unit 130 configured to measure the voltage of the target battery.

The measuring unit 130 may be configured to measure the voltage of the target battery at a predetermined voltage measurement period during the battery charging or discharging process. The measuring unit 130 may employ various voltage measurement technologies known at the time of filing the present disclosure. For example, the measuring unit 130 may include a voltage sensor known at the time of filing the present disclosure. In particular, the voltage sensor already provided in the battery pack including the target battery according to the present disclosure may be used as the measuring unit 130 according to the present disclosure.

The control unit 120 may be configured to generate a full-cell profile Tf for the target battery based on the voltage measured from the measuring unit 130. That is, if the voltage is measured by the measuring unit 130, the measured voltage information may be transmitted from the measuring unit 130 to the control unit 120. Also, based on the transmitted voltage information, the control unit 120 may generate a full-cell profile Tf indicating the corresponding relationship between voltage and capacity for the target battery to be diagnosed. In other words, the full-cell profile Tf of the target battery means a profile that represents the one-to-one corresponding relationship between the voltage and the SOC for the entire SOC section of the target battery.

The control unit 120 may be configured to obtain a positive electrode target profile Tp and a negative electrode target profile Tn from the full-cell profile Tf. That is, the control unit 120 may non-destructively obtain the positive electrode target profile Tp and the negative electrode target profile Tn without disassembling the target battery, rather than disassembling the target battery in advance to obtain individual electrode profiles (positive electrode target profile Tp and negative electrode target profile Tn).

Specifically, the control unit 120 may adjust the positive electrode reference profile Rp and the negative electrode reference profile Rn to correspond to the full-cell profile Tf of the target battery.

For convenience of understanding, the full-cell profile Rf of the reference battery and the full-cell profile Tf of the target battery are shown together in FIG. 4. The control unit 120 may adjust the positive electrode reference profile Rp and the negative electrode reference profile Rn to correspond to the full-cell profile Tf of the target battery by shifting or reducing and/or expanding the positive electrode reference profile Rp and the negative electrode reference profile Rn in the x-axis direction. That is, since the difference between the positive electrode reference profile Rp and the negative electrode reference profile Rn is the full-cell profile Rf of the reference battery, the control unit 120 may adjust the positive electrode reference profile Rp and the negative electrode reference profile Rn so that the full-cell profile Rf of the reference battery and the full-cell profile Tf of the target battery correspond to each other.

Specifically, the fact that the full-cell profile Rf of the reference battery and the full-cell profile Tf of the target battery correspond to each other may mean that the forms of the two profiles are similar. For example, the control unit 120 may obtain an adjusted positive electrode reference profile and an adjusted negative electrode reference profile that minimize the error between the two profiles. Alternatively, the control unit 120 may generate a plurality of adjusted positive electrode reference profiles and a plurality of adjusted negative electrode reference profiles by varying the degree of shift and the degree of reduction and/or expansion in the x-axis direction. The control unit 120 may determine an adjusted positive electrode reference profile (adjustment positive electrode reference profile) and an adjusted negative electrode reference profile (adjustment negative electrode reference profile) whose root mean square error (RMSE) is minimized from the full-cell profile Tf of the target battery among the generated plurality of adjusted positive electrode reference profiles and adjusted negative electrode reference profiles. The full-cell profile of the reference battery corresponding to the difference between the determined adjusted positive electrode reference profile and the adjusted negative electrode reference profile may be said to have the most similar form to the full-cell profile Tf of the target battery. Accordingly, the control unit 120 may obtain the determined adjusted positive electrode reference profile and the determined adjusted negative electrode reference profile as the above-described positive electrode target profile Tp and the above-described negative electrode target profile Tn. In this way, the control unit 120 may obtain the positive electrode target profile Tp and the negative electrode target profile Tn by adjusting the positive electrode reference profile Rp and the negative electrode reference profile Rn in an easy and simple way without disassembling and analyzing the target battery.

Additionally, the apparatus 100 for diagnosing pre-lithiation according to the present disclosure may be provided in a battery manufacturing device. That is, the battery manufacturing device may include at least some components of the apparatus 100 for diagnosing pre-lithiation according to the present disclosure. For example, the battery manufacturing device may include the control unit 120 according to the present disclosure. The battery manufacturing device may be configured to manufacture a target battery and verify performance of the manufactured target battery before it is shipped.

The battery manufacturing process may include an electrode process that manufactures an electrode, an assembly process that assembles the manufactured electrode, and an activation process that gives electrical characteristics to the assembled battery (target battery) through charging and discharging. In various embodiments, the battery manufacturing process may further include the pre-lithiation process described above.

The battery manufacturing device may diagnose whether the pre-lithiation process has been successfully performed in the above-described manner without disassembling the manufactured target battery after the assembly process or activation process, that is, before the battery is shipped. In other words, the battery manufacturing device may quantitatively calculate the amount of lithium supplied to the negative electrode, which is the lithium charge amount, through the pre-lithiation process to determine whether the pre-lithiation process has been successfully performed, and diagnose whether the target battery is defective or not according to the results. Therefore, the battery manufacturing device may diagnose the state of the target battery in a simple way without disassembling the target battery, and thus may have high reliability about the state of the battery.

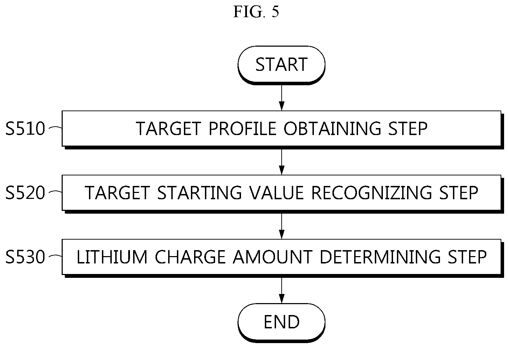

FIG. 5 is a flowchart schematically showing a method for diagnosing pre-lithiation according to an embodiment of the present disclosure. In FIG. 5, the subject of each step may be each component of the apparatus 100 for diagnosing pre-lithiation according to the present disclosure described above.

Referring to FIG. 5, the method for diagnosing pre-lithiation according to the present disclosure may include a target profile obtaining step (S510), a target starting value recognizing step (S520), and a lithium charge amount determining step (S530).

The target profile obtaining step (S510) is a step of obtaining a positive electrode target profile Tp and a negative electrode target profile Tn for a target battery to be diagnosed, and may be performed by the control unit 120.

As an example, the control unit 120 may obtain the positive electrode target profile Tp and the negative electrode target profile Tn previously stored in the memory unit 110.

Preferably, the control unit 120 may obtain the positive electrode target profile Tp and the negative electrode target profile Tn separately from the full-cell profile representing the voltage for the target battery. In this case, the target profile may not be stored in the memory unit 110 in advance, so there is an advantage of not requiring high-capacity memory resources, and it has the advantage of being able to non-destructively obtain the negative electrode target profile Tn and the positive electrode target profile Tp from the full-cell profile, without disassembling the target battery to obtain the negative electrode target profile Tn and the positive electrode target profile Tp.

Specifically, the control unit 120 may receive voltage information indicating the voltage of the target battery from the measuring unit 130 configured to measure the voltage of the target battery. The control unit 120 may generate a full-cell profile for the target battery based on the measured voltage. An embodiment in which the control unit 120 obtains the positive electrode target profile Tp and the negative electrode target profile Tn from the full-cell profile has already been described using FIG. 4, so redundant description will be omitted.

The target starting value recognizing step (S520) is a step of recognizing a positive electrode target starting value and a negative electrode target starting value from the positive electrode target profile Tp and the negative electrode target profile Tn, and may be performed by the control unit 120.

Specifically, the positive electrode target starting value and the negative electrode target starting value may mean the characteristic value of the positive electrode and the characteristic value of the negative electrode when the target battery corresponds to a predetermined SOC. Specifically, the positive electrode target starting value may mean a positive electrode SOC or a positive electrode voltage value when the target battery corresponds to the predetermined SOC, and the negative electrode target starting value may mean a negative electrode SOC or a negative electrode voltage value when the target battery corresponds to the predetermined SOC. The information about the negative electrode target starting value and the positive electrode target starting value may be stored in the memory unit 110 in the form of a mapping table. In one embodiment, when the SOC of the target battery is 0%, the control unit 120 may recognize the negative electrode target starting value corresponding to the SOC of the negative electrode and the positive electrode target starting value corresponding to the SOC of the positive electrode.

The lithium charge amount determining step (S530) is a step of determining a lithium charge amount pre-charged in the target battery through the pre-lithiation process based on at least one of the positive electrode reference starting value, the negative electrode reference starting value, the positive electrode target starting value and the negative electrode target starting value for the target battery, and may be performed by the control unit 120.

The positive electrode reference starting value and the negative electrode reference starting value may mean the characteristic value of the positive electrode and the characteristic value of the negative electrode when the reference battery corresponds to a predetermined SOC. In one embodiment, the positive electrode reference starting value may refer to a positive electrode SOC or a positive electrode voltage value when the reference battery corresponds to the predetermined SOC, and the negative electrode reference starting value may refer to a negative electrode SOC or a negative electrode voltage value when the reference battery corresponds to the predetermined SOC. The information about the negative electrode reference starting value and the positive electrode reference starting value may be stored in the memory unit 110 in the form of a mapping table. Here, the SOC of the reference battery for obtaining the above-described positive electrode reference starting value and the above-described negative electrode reference starting value and the SOC of the target battery for obtaining the positive electrode target starting value and the above-described negative electrode target starting value may be the same.

The control unit 120 may calculate the lithium charge amount of the target battery pre-charged in the pre-lithiation process by calculating at least two parameters selected from the positive electrode reference starting value, the negative electrode reference starting value, the positive electrode target starting value, and the negative electrode target starting value.

In one embodiment, the control unit 120 calculate the lithium charge amount for the target battery based on the third difference corresponding to the difference between the first difference corresponding to the formula of "|negative electrode reference starting value - negative electrode target starting value|" and the second difference corresponding to the formula of "|negative electrode target starting value - positive electrode target starting value|". Preferably, since it has already been explained that the lithium charge amount is calculated based on the above formulas and the loading amount of the target battery, detailed explanation will be omitted.

In relation to the steps S510 to S530, the contents of the apparatus 100 for diagnosing pre-lithiation according to the present disclosure described above may be applied in the same or similar manner. Therefore, detailed descriptions of each step of the method for diagnosing pre-lithiation according to the present disclosure are omitted.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

100: apparatus for diagnosing pre-lithiation
110: memory unit
120: control unit
130: measuring unit

## Claims

1. An apparatus for diagnosing pre-lithiation, comprising:
a memory unit storing a positive electrode reference starting value and a negative electrode reference starting value for a reference battery; and
a control unit configured to obtain a positive electrode target profile and a negative electrode target profile for a target battery to be diagnosed, recognize a positive electrode target starting value and a negative electrode target starting value from the positive electrode target profile and the negative electrode target profile, and determine a lithium charge amount of a pre-lithiation process for the target battery based on at least one of the positive electrode reference starting value, the negative electrode reference starting value, the positive electrode target starting value, and the negative electrode target starting value.

2. The apparatus for diagnosing pre-lithiation according to claim 1,
wherein the control unit is configured to determine the lithium charge amount based on the negative electrode reference starting value and the negative electrode target starting value.

3. The apparatus for diagnosing pre-lithiation according to claim 2,
wherein the control unit is configured to calculate a difference between the negative electrode reference starting value and the negative electrode target starting value and determine the lithium charge amount based on the calculated difference and a preset positive electrode loading amount.

4. The apparatus for diagnosing pre-lithiation according to claim 1,
wherein the control unit is configured to determine the lithium charge amount based on a first difference between the negative electrode reference starting value and the positive electrode reference starting value and a second difference between the negative electrode target starting value and the positive electrode target starting value.

5. The apparatus for diagnosing pre-lithiation according to claim 4,
wherein the control unit is configured to calculate a third difference between the first difference and the second difference and determine the lithium charge amount based on the calculated third difference and a preset positive electrode loading amount.

6. The apparatus for diagnosing pre-lithiation according to claim 1,
wherein the reference battery includes is a battery to which no lithium is charged or a preset amount of lithium is charged in the pre-lithiation process.

7. The apparatus for diagnosing pre-lithiation according to claim 1,
wherein the positive electrode reference starting value and the negative electrode reference starting value are configured to be set as a positive electrode SOC and a negative electrode SOC of the reference battery, respectively, when a SOC of the reference battery corresponds to a preset reference SOC.

8. The apparatus for diagnosing pre-lithiation according to claim 1, further comprising a measuring unit configured to measure a voltage of the target battery,
wherein the control unit is configured to generate a full-cell profile for the target battery based on the voltage measured from the measuring unit and obtain the positive electrode target profile and the negative electrode target profile from the full-cell profile.

9. The apparatus for diagnosing pre-lithiation according to claim 8,
wherein the memory unit is configured to store a positive electrode reference profile and a negative electrode reference profile for the reference battery, and
wherein the control unit is configured to obtain the positive electrode target profile and the negative electrode target profile, respectively, by adjusting the positive electrode reference profile and the negative electrode reference profile to correspond to the full-cell profile.

10. The apparatus for diagnosing pre-lithiation according to claim 1,
wherein the control unit is configured to compare the lithium charge amount and a preset reference charge amount and diagnose a state of the target battery based on the comparison result.

11. A battery manufacturing device, comprising the apparatus for diagnosing pre-lithiation according to any one of claims 1 to 10.

12. A method for diagnosing pre-lithiation, comprising:
a target profile obtaining step of obtaining a positive electrode target profile and a negative electrode target profile for a target battery to be diagnosed;
a target starting value recognizing step of recognizing a positive electrode target starting value and a negative electrode target starting value from the positive electrode target profile and the negative electrode target profile; and
a lithium charge amount determining step of determining a lithium charge amount of a pre-lithiation process for the target battery based on at least one of a positive electrode reference starting value for a reference battery, a negative electrode reference starting value for the reference battery, the positive electrode target starting value, and the negative electrode target starting value.
